# EUROPEAN PATENT SPECIFICATION

(11) **EP 1 894 903 B1**
(45) Date of publication and mention of the grant of the patent: **04.11.2009**
(21) Application number: 07014102.3
(22) Date of filing: 18.07.2007
(51) Int. Cl.: C03C 27/00, H01L 21/50, H01L 21/58, B81C 3/00, B81C 1/00

(54) **Anodic bonding apparatus**
Anodische Bindungsvorrichtung
Appareil de liaison anodique

(30) Priority: 18.07.2006 JP 2006195018
(43) Date of publication of application: 05.03.2008
(73) Proprietor: SHINKO ELECTRIC INDUSTRIES CO., LTD., Nagano-shi, Nagano 381-2287 (JP)
(72) Inventor: Mizuno, Takayoshi, Nagano 381-2287 (JP)
(74) Representative: Zimmermann, Gerd Heinrich

(56) References cited:
- WO-A-03/006396
- WO-A-2004/113837
- JP-A- 8 330 200
- US-A1- 2006 228 824

## Description

The present invention relates to an anodic bonding apparatus. More particularly, it relates to an anodic bonding apparatus whereby a laminate of an electrically conductive substrate and a glass substrate stacked in the vertical direction and heated in a container of which pressure is capable of being reduced is interposed between an upper electrode and a lower electrode, and applied with a direct current voltage such that the electrically conductive substrate is an anode and such that the glass substrate is a cathode, thereby to bond the electrically conductive substrate and the glass substrate.

Anodic bonding is a technology for bringing objects to be bonded in direct contact with each other without using an adhesive, solder, or the like, and thereby bonding them. It has been widely applied to bonding between an electrically conductive substrate such as a silicon wafer and a glass substrate. Particularly, it is most often applied to a combination of silicon excellent in mechanical characteristics, processability, and the like, and borosilicate glass approximately equal in thermal expansion coefficient to silicon. Thus, it becomes an important manufacturing technology of a semiconductor device such as a semiconductor sensor or a semiconductor actuator. As for the combination of silicon and borosilicate glass, the following method is general. Substrates to be bonded are stacked one on another, and heated to and stabilized at about 300 to 400 °C. Then, the glass substrate is set at a negative electric potential, and the silicon wafer is set at a positive electric potential and a direct current voltage of about 500 to 600 V is applied thereto, thereby to bond both the substrates.

The semiconductor devices thus manufactured by anodic bonding are mostly used for precision equipment. For this reason, they are especially required to have reliability as products. However, with anodic bonding, conventionally, unbonded sites (voids) have been unfavorably likely to occur. Products including voids degrade the reliability of the equipment as defective products. Thus, how voids are prevented from occurring has become a large problem.

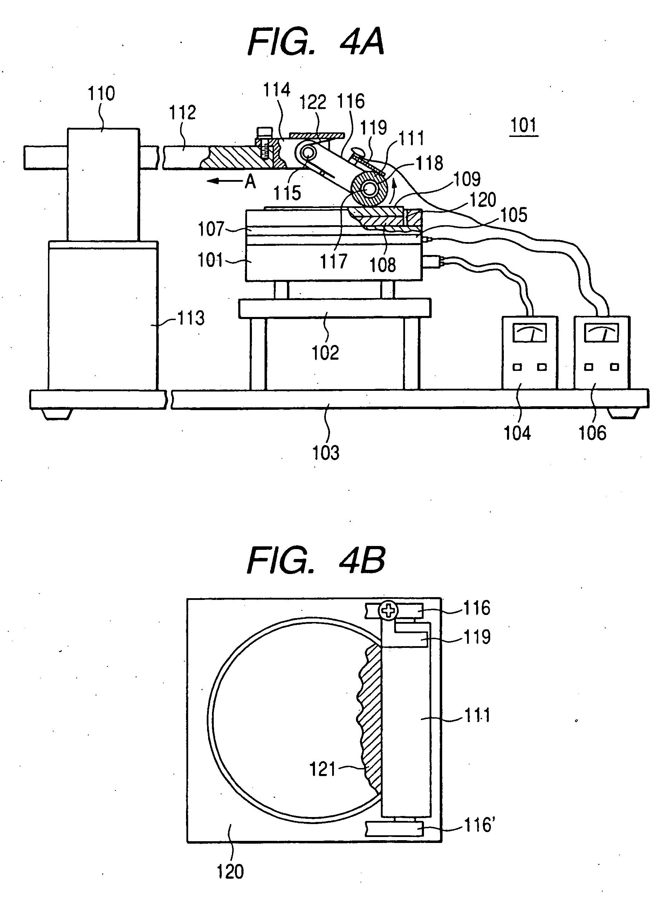

As a conventional anodic bonding apparatus capable of preventing the occurrence of voids in anodically bonding an electrically conductive substrate such as a silicon wafer and a glass substrate, there is proposed an anodic bonding apparatus 101 described in Reference 1 and shown in Fig. 4A.

The conventional example is configured as follows. Fig. 4B shows a top view of a periphery of a cylindrical electrode. A cylindrical electrode 111 is rotatably mounted at arms 116 and 116' shown in Fig. 4B, and continuously pressed against a glass substrate 109 by a screw recoil spring 122. Thus, the cylindrical electrode 111 is translated from the edge at which a silicon wafer 108 and a glass substrate 109 are stacked one on another by driving of a motor 110, thereby to successively expand the bonded area.

However, in this conventional example, anodic bonding is carried out in the atmosphere. Therefore, unfavorably, air which is one of the factors causing the occurrence of voids becomes more likely to enter the bonding surface. (See, e.g., JP-A-8-330200)

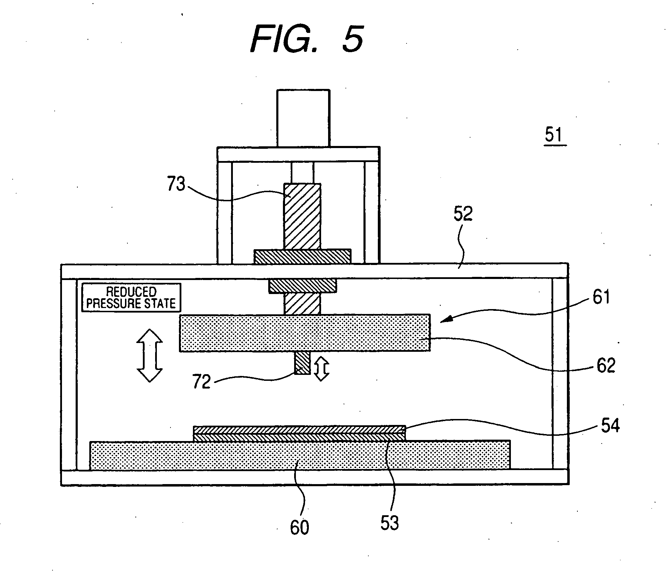

On the other hand, as an embodiment conventionally performed by the applicant of the present application, there is an anodic bonding apparatus 51 shown in Fig. 5.

The anodic bonding apparatus 51 is configured as follows. The inside of a container 52 is evacuated. Thus, with an upper electrode 61 and a lower electrode 60 provided in the container 52, an electric potential is caused between an electrically conductive substrate 53 and a glass substrate 54, and anodic bonding is carried out in vacuum. Therefore, the anodic bonding apparatus 51 is very effective in terms of being capable of discharging air which causes voids.

Further, a protruding small electrode 72 is disposed at the central portion of a contact plate 62 of the upper electrode 61. First, it is brought in contact with the central portion of the laminate of the electrically conductive substrate 53 and the glass substrate 54 to perform bonding of the area. Then, the upper electrode 61 is further moved downward to carry out bonding of the entire surfaces of the substrates. Thus, it is possible to proceed with bonding thereof while expelling air which may cause voids from the central portion to the outer edge of the substrates.

However, with anodic bonding using the conventional anodic bonding apparatus 51 shown in Fig. 5, unless the contact plate 62 and the substrate 54 are set in parallel with each other with high precision, unfavorably, the contact plate 62 comes in partial contact with the substrate 54. The partial contact thereof causes breakage of the substrate 54, and further may cause the occurrence of voids. For this reason, prevention of such partial contact has become a problem.

In light of the above, the anodic bonding apparatus according to independent claims 1 and 5 are provided.

Further advantages, features, aspects and details of the invention are evident from the dependent claims, the description and the drawings. The invention provides an anodic bonding apparatus, whereby in anodic bonding in which a laminate of an electrically conductive substrate and a glass substrate, stacked in the vertical direction and heated in a container of which pressure is capable of being reduced, is interposed between an upper electrode and a lower electrode, and a direct current voltage is applied thereto such that the electrically conductive substrate is an anode and such that the glass substrate is a cathode, and the electrically conductive substrate and the glass substrate are bonded, the occurrence of voids due to inclusion of air is prevented, and breakage of the substrates to be bonded and the occurrence of voids due to partial contact of the upper electrode are prevented.

The present invention is mainly directed to the independent apparatus claim 1.

2. The anodic bonding apparatus according to item 1, wherein the electrically conductive metal thin plate is positioned at.the main body part such that, when the electrically conductive metal thin plate swells in a convex form in the direction of the laminate, the tip of the swelling matches the vicinity of the central portion of the laminate.
3. The anodic bonding apparatus according to item 1 or 2, wherein an air pressure adjuster is disposed at a point in a channel through which the fluid is supplied into and drained from the space part.
4. The anodic bonding apparatus according to any one of items 1 to 3, wherein the electrically conductive metal thin plate comprises a stainless steel alloy thin plate.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, a computer programmed by appropriate software, by any combination thereof or in any other manner.

In accordance with one or more embodiments of the invention, it becomes possible to proceed an anodic bonding steplessly while expelling air which may cause voids from the center portion toward the outer edge of the laminate of the electrically conductive substrate and the glass substrate.

Further, it is possible to cancel the partial contact of the upper electrode. As a result, it becomes possible to resolve the problems such as breakage of the substrates and the occurrence of voids.

In accordance with one or more embodiments of the invention, the tip which has swollen in a convex form of the electrically conductive metal thin plate is matched with the central portion of the laminate of the electrically conductive substrate and the glass substrate. As a result, it becomes possible to proceed with anodic bonding while expelling air which may cause voids concentrically from the center portion toward the outer edge.

In accordance with one or more embodiments of the invention, the pressure reduction adjustment of the air pressure adjuster can reduce the pressure of the space part of the upper electrode.

Whereas, in the case where the electrically conductive metal thin plate is not deformed into generally a sphere only by applying the space part of the upper electrode with atmospheric pressure, or other cases, by increasing the pressure in the space part of the upper electrode to atmospheric pressure or larger by pressure increase adjustment of the air pressure adjuster, it is possible to deform the electrically conductive metal thin plate into a desired form.

Further, it becomes possible to control the pressing pressure against the laminate by controlling the pressure difference between the pressure in the container and the pressure of the space part of the upper electrode.

In accordance with one or more embodiments of the invention, the electrically conductive metal thin plate forms the upper electrode in a diaphragm structure capable of elastic deformation, and is preferred to have an electrical conductivity. For this reason, it is effective to adopt a thin plate of a stainless steel alloy.

In accordance with one or more embodiments of the invention, it becomes possible to proceed anodic bonding step by step while expelling air which may cause voids from the center portion toward the outer edge of the laminate of the electrically conductive substrate and the glass substrate.

Further, it is possible to cancel the partial contact of the upper electrode. As a result, it becomes possible to resolve the problems such as breakage of the substrate and the occurrence of voids.

Furthermore, other advantages and effects of some aspect of the invention will become apparent from the following description.

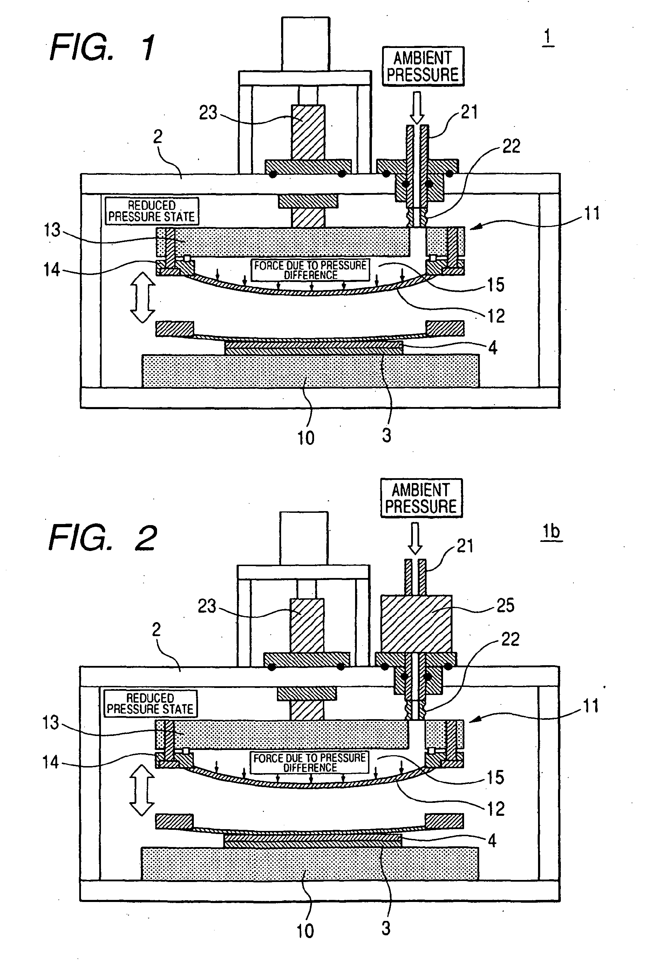

The invention will be better understood by reference to the following description of embodiments of the invention taken in conjunction with the accompanying drawings, wherein: Fig. 1 is a schematic diagram showing an example of an anodic bonding apparatus in accordance with a first embodiment of the present invention.

Fig. 2 is a schematic diagram showing an example of an anodic bonding apparatus in accordance with a second embodiment of the invention.

Fig. 3 is a schematic diagram showing an example of an anodic bonding apparatus in accordance with a third embodiment of the invention.

Figs. 4A and 4B are schematic diagrams each showing an example of an anodic bonding apparatus in accordance with a conventional embodiment.

Fig. 5 is a schematic diagram showing another example of an anodic bonding apparatus in accordance with a conventional embodiment.

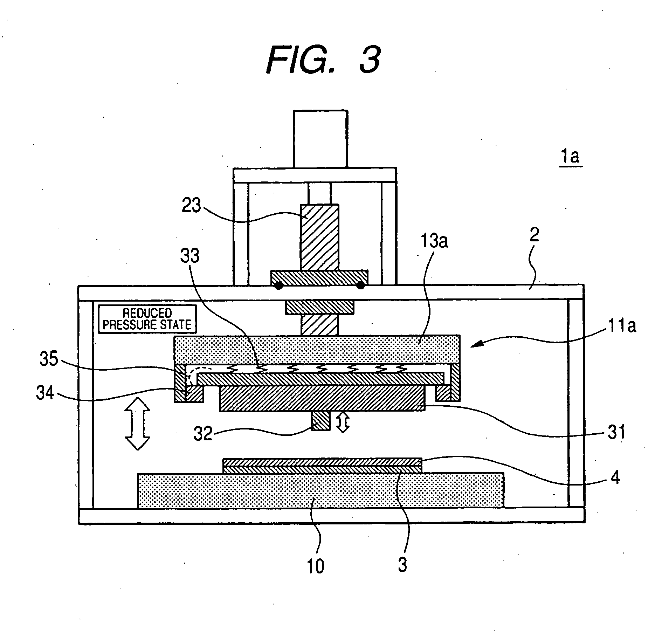

Below, the present invention will be described in details by way of embodiments with reference to the accompanying drawings. Fig. 1 is a schematic diagram showing an example of an anodic bonding apparatus 1 in accordance with a first embodiment of the invention. Fig. 2 is a schematic diagram showing an example of an anodic bonding apparatus 1b in accordance with a second embodiment of the invention. Fig. 3 is a schematic diagram showing an example of an anodic bonding apparatus 1 a in accordance with a third embodiment of the invention.

As shown in Fig. 1, the anodic bonding apparatus 1 includes an upper electrode 11 and a lower electrode 10 provided in a container 2. The upper electrode 11 and the lower electrode 10 cause electric potentials to an electrically conductive substrate 3 and a glass substrate 4.

The electrically conductive substrate 3 and the glass substrate 4 are stacked one on another in the vertical direction, and set on the lower electrode 10. As one example, on the lower electrode 10 side, the electrically conductive substrate 3 is set, and on the upper electrode 11 side, the glass substrate 4 is set. In that case, the lower electrode 10 is set at a positive electric potential, and the upper electrode 11 is set at a negative electric potential. Thus, different electric potentials are created at respective substrates.

Incidentally, it is naturally understood that the following may be adopted. On the lower electrode 10 side, the glass substrate 4 is set, and on the upper electrode 11 side, the electrically conductive substrate 3 is set. Thus, the lower electrode 10 is set at a negative electric potential, and the upper electrode 11 is set at a positive electric potential.

The upper electrode 11 is connected to a driving mechanism 23, and disposed movably in the vertical direction in the container 2. The driving mechanism 23 generates a driving force for moving the upper electrode 11. For the driving mechanism 23, as one example, a ball screw is used.

As an action thereof, the upper electrode 11 can be moved downward vertically to come in contact with the glass substrate 4. Further, the amount of movement is adjustable steplessly.

Incidentally, in place of the upper electrode 11, or together with the upper electrode 11, the lower electrode 10 may be disposed movably in the vertical direction in the container 2.

The upper electrode 11 is provided on the underside with an electrically conductive metal thin plate 12 to come in contact with the glass substrate 4. Generally, a substrate is in the form of a circle. Therefore, as one example, the electrically conductive metal thin plate 12 is also similarly configured in the form of a circle. In general, the size of the electrically conductive metal thin plate 12 is larger in outer diameter than that of the electrically conductive substrate 3 and the glass substrate 4 to be anodically bonded. However, bonding of a wider area than the contact area is possible. Therefore, a smaller outer diameter than that of the electrically conductive substrate 3 and the glass substrate 4 is acceptable according to the bonding conditions.

The outer perimeter of the electrically conductive metal thin plate 12 is entirely welded to a support portion 14. The support portion 14 is bonded to a main body part 13. As a result, the upper electrode 11 is configured in such a diaphragm structure as shown in Fig. 1.

Herein, the electrically conductive metal thin plate 12 is required to be a material which is capable of being elastically deformed, and is electrically conductive. As one example, there is adopted a thin plate of a stainless steel alloy with a thickness of about 0.5 mm or larger. The thickness has no particular restriction. However, when the thickness is too small, there occurs a possibility that the rupture is caused by a pressure difference when the inside of the container 2 has been evacuated. Whereas, when the thickness is too large, the electrically conductive metal thin plate 12 cannot be deformed into an approximate sphere shape even when the inside of the container 2 is evacuated. Therefore, the thickness is set to such a proper thickness as to produce the effects of the invention.

Whereas, the material for the electrically conductive metal thin plate 12 was a stainless steel alloy. However, other metals such as an aluminum alloy are acceptable. However, use of a steel material causes carbon to be separated and precipitated under vacuum. For this reason, when the inside of the container 2 is evacuated to perform bonding, steel materials are not suitable as the materials for the electrically conductive metal thin plate 12.

To the main body part 13, a fluid supply and drainage channel 21 is connected. The fluid supply and drainage channel 21 causes a space part 15 of the upper electrode 11 to communicate with the outside of the container without loss of the closed condition of the inside of the container 2. For the whole of, or a part of the channel of the fluid supply and drainage channel 21, a bellows structure 22 is adopted. This enables ensuring of the channel through which a fluid is supplied and drained even when the upper electrode 11 moves in the vertical direction. Incidentally, the mechanism of ensuring of the channel is not limited to the bellows structure 22. A configuration using a flexible pipe or the like is also acceptable.

The upper electrode 11 configured to include the fluid supply and drainage channel 21, and to be in a diaphragm structure has the following action. A pressure difference between a pressure in the container 2 and the air pressure of the space part 15 of the upper electrode 11 communicating with air outside the container increases with a decrease in air pressure in the container 2. By the inner pressure of the space part 15, the electrically conductive metal thin plate 12 is deformed into generally a sphere with the central portion most closely approaching the glass substrate 4 as shown in Fig. 1.

The anodic bonding apparatus 1 in accordance with an embodiment of the invention is configured as described above. In addition, the electrically conductive plate 3 and the glass substrate 4 are anodically bonded to each other. First, the inside of the container 2 is reduced in pressure to be evacuated. The term "vacuum" herein referred to is not limited to a perfect vacuum condition. When the upper electrode 11, which has been deformed into generally a sphere with the central portion of the underside of the electrically conductive metal thin plate 12 most closely approaching the glass substrate 4 by the pressure reduction of the inside of the container 2, is moved downward, the contact with the central portion of the glass substrate 4 is started by point contact. By the contact, the upper electrode 11 creates a negative electric potential on the glass substrate 4, and the lower electrode 10 creates a positive electric potential on the electrically conductive substrate 3. Thus, bonding between the electrically conductive substrate 3 and the glass substrate 4 is started. The applied voltage is, as one example, a direct current voltage of 600 V.

At this step, the electrically conductive metal thin plate 12 is positioned at the main body part so that the tip of the swelling matches the vicinity of the central portion of the laminate when the electrically conductive metal thin plate 12 swells in a convex form in the direction of the laminate. As a result, it becomes possible to proceed with the bonding between the electrically conductive substrate 3 and the glass substrate 4 while expelling air concentrically from the substrate center toward the direction of the outer edge of the substrate.

With anodic bonding, in general, a little larger region than the contact region undergoes bonding. Upon completion of bonding, the applied current decreases. Therefore, by gradually increasing the contact area with the decrease in applied current, the occurrence of voids is prevented, which enables uniform bonding of the entire surface. It is also an advantage of the apparatus in accordance with an embodiment of the invention that the apparatus can carry out the contact area adjustment steplessly.

Thus, the pressure reduction to vacuum of the inside of the container 2 produces an effect of capable of expelling air causing the occurrence of voids outside the container 2. In addition, it produces an effect of relatively increasing the pressure inside the space part 15 of the upper electrode 11 formed in a diaphragm structure, and thereby enabling deformation of the electrically conductive metal thin plate 12 into generally a sphere.

In order to prevent the occurrence of voids at the bonding part between the substrates, it is ideal to bond the central portions of the substrates, and to gradually proceed with the bonding toward the outer edges of the substrates. This is because the process enables the air which may cause voids to be expelled.

In this regard, the electrically conductive metal thin plate 12 is formed in generally a sphere with the central portion protruding, and hence comes in contact therewith at the central portion. The region is subjected to bonding. Further, when the upper electrode 11 is moved downward, the contact region expands. Thus, bonding is carried out within the region. Still further, the upper electrode 11 is moved downward. By this repetition, it becomes possible to gradually proceed with the bonding while expelling air which may cause voids from the central portion toward the outer edge of each substrate. Thus, it is possible to finally complete the bonding of the entire surface.

At this step, the air in the space part 15 of the upper electrode 11 formed in a diaphragm structure is compressed by the contact between the electrically conductive metal thin plate 12 and the laminate. As a result, a part of the air is automatically expelled to the outside of the container through the fluid supply and drainage channel 21.

As the effects of the foregoing action, it is possible to apply a uniform pressing pressure to the entire surface by the pressure difference. In addition, it is possible to control the pressing pressure by controlling the pressure difference by the amount of pressure reduced in the container 2, or the like. As a result, it becomes possible to solve the problems such as breakage of the substrates and the occurrence of voids due to the partial contact with the electrode.

Whereas, when anodic bonding is carried out, the electrically conductive substrate 3 and the glass substrate 4 are required to be heated. As for this, a heat source (not shown) is mounted in the main body part 13 of the upper electrode 11. Thus, the electrically conductive metal thin plate 12 is heated via.the support portion 14. The heated electrically conductive metal thin plate 12 comes in contact with the glass substrate 4, so that the glass substrate 4 is heated. The heating method has no particular restriction. However, for example, there is a method in which the heat source to be mounted is a resistance wire heater. Incidentally, even the following method is acceptable. A lamp heater is set on the underside of the main body part 13 for heating by irradiation on the top surface of the electrically conductive metal thin plate 12.

On the other hand, a heat source (not shown) is also mounted in the lower electrode 10. The heat source is, for example, a resistance wire heater. By heating the lower electrode 10, the electrically conductive substrate 3 is heated.

In the foregoing manner, it is possible to heat the electrically conductive substrate 3 and the glass substrate 4. As one example, it is configured such that the electrically conductive substrate 3 and the glass substrate 4 are heated to 300 °C.

As described up to this point, with the anodic bonding apparatus 1 in accordance with an embodiment of the invention, it becomes possible to proceed the anodic bonding steplessly in a decompression container in which air causing the occurrence of voids has been reduced, and further while expelling air which may cause voids from the central portion toward the outer edge of each substrate.

Further, it is possible to cancel the partial contact of the upper electrode 11. As a result, it becomes possible to resolve the problems such as breakage of the substrates and the occurrence of voids.

Whereas, it is possible to apply uniform pressing pressure on the entire surfaces of the substrates to be bonded. Further, by changing the setting of the amount of pressure to be reduced in the container 2, the setting of the thickness of the electrically conductive metal thin plate 12, and the like, it is possible to control the pressing pressure.

As a second embodiment of the invention, an anodic bonding apparatus 1b including an air pressure adjuster 25 at a point in the fluid supply and drainage channel 21 is shown in Fig. 2.

By allowing the air pressure adjuster 25 to have a pressure reducing function, the following effects can be produced. For example, in the case that a thin plate material is used for the electrically conductive metal thin plate 12, and the inside of the container 2 is evacuated, and the inside of the upper electrode 11 is applied with atmospheric pressure, the electrically conductive metal thin plate 12 may be broken by the pressure difference. In such a case, or other cases, the pressure in the space part 15 of the upper electrode 11 is reduced to prevent the breakage.

On the other hand, by allowing the air pressure adjuster 25 to have a pressure increasing function, the following effects can be produced. For example, when a thick plate material is used for the electrically conductive metal thin plate 12 and the inside of the container 2 is evacuated, it may cause that the electrically conductive metal thin plate 12 is not deformed into generally a sphere only by applying the inside of the upper electrode 11 with atmospheric pressure. Even in such a case, the pressure in the upper electrode 11 is increased to atmospheric pressure or larger to deform the electrically conductive metal thin plate 12 into a desired form.

Further, by increasing the pressure of the inside of the space part 15 of the upper electrode 11 of a diaphragm structure, the electrically conductive metal thin plate 12 can be deformed into generally a sphere. This eliminates the necessity of evacuating the container 2. In such a case, it is also conceivable that a simple apparatus configuration not including the container 2 is adopted. Alternatively, even when the container 2 is not omitted, and when a necessity of achieving vacuum is eliminated, the occurrence of voids is prevented only by keeping the container 2 in a mere clean room state.

The air pressure adjuster 25 can apply a uniform pressing pressure to the entire surfaces of the substrates to be bonded. In addition, it can control the pressing pressure by controlling the pressure difference.

Incidentally, in this embodiment, the target to be adjusted by the air pressure adjuster 25 is air. However, pressure adjustment may be accomplished by the use of a liquid as with, for example, a hydraulic mechanism.

An anodic bonding apparatus 1a in accordance with a third embodiment of the invention is shown in Fig. 3.

The anodic bonding apparatus 1a includes an upper electrode 11a and a lower electrode 10 provided in a container 2. The upper electrode 1a and the lower electrode 10 cause electric potentials to an electrically conductive substrate 3 and a glass substrate 4.

The electrically conductive substrate 3 and the glass substrate 4 are brought in contact with each other, and set on the lower electrode 10. As one example, on the lower electrode 10 side, the electrically conductive substrate 3 is set, and on the upper electrode 11a side, the glass substrate 4 is set. In that case, the upper electrode 11a is set at a negative electric potential, and the lower electrode 10 is set at a positive electric potential.

Incidentally, it is naturally understood that the following may be adopted. On the lower electrode 10 side, the glass substrate 4 is set, and on the upper electrode 11a side, the electrically conductive substrate 3 is set. Thus, the lower electrode 10 is set at a negative electric potential, and the upper electrode 11a is set at a positive electric potential.

The upper electrode 11a is connected to a driving mechanism 23, and disposed movably in the vertical direction in the container 2. The driving mechanism 23 creates a driving force for moving the upper electrode 11a. For the driving mechanism 23, as one example, a ball screw is used.

As an action thereof, the upper electrode 11 a can be moved downward vertically to come in contact with the glass substrate 4. Further, the amount of movement is adjustable steplessly.

Incidentally, in place of the upper electrode 11a, or together with the upper electrode 11a, the lower electrode 10 may be disposed movably in the vertical direction in the container 2.

With the configuration of the upper electrode 11a, a contact plate 31 to be brought in contact with the glass substrate 4 is provided at the lower part. Generally, a substrate is in the form of a circle. Therefore, as one example, the contact plate 31 is also similarly configured in the form of a circle. In general, the size of the contact plate 31 is approximately equal in outline to that of the electrically conductive substrate 3 and the glass substrate 4 to be anodically bonded. When the contact plate 31 is too large, discharge may occur between the contact plate 10 and the lower electrode 10. Incidentally, bonding of a wider area than the contact area is possible. Therefore, the size of the contact plate 31 may be smaller in outer diameter than that of the electrically conductive substrate 3 and the glass substrate 4 according to the bonding conditions.

A biasing member 33 is provided between the contact plate 31 and the main body part 13a. A contact plate outer edge 35 is engaged with a contact plate engagement part 34 in a pressed state by the action of the biasing member 33. The contact plate engagement part 34 is bonded to the main body part 13a.

A small electrode 32 is disposed at the central portion of the underside of the contact plate 31. The small electrode 32 is held in a state protruding from the underside of the contact plate 31 in the state before the start of bonding. The small electrode 32 is configured so as to be pressed upward by the contact with the substrate, and thereby to be brought into the contact plate 31.

Herein, examples of the materials for the contact plate 31 and the small electrode 32 to be used include carbon and stainless steel alloy. However, other metals such as aluminum alloys are also acceptable. However, when a steel material is used, carbon is separated and precipitated under vacuum. Therefore, the steel material is not suitable as the material for the contact plate 31 and the small electrode 32 in the case where the inside of the container 2 is evacuated to perform bonding.

The anodic bonding apparatus 1a is configured as described above. In addition, the electrically conductive plate 3 and the glass substrate 4 are anodically bonded to each other. First, the inside of the container 2 is reduced in pressure to be evacuated. The term "vacuum" herein referred to is not limited to a perfect vacuum condition. Subsequently, the upper electrode 11a is moved downward. At this step, the small electrode 32 disposed in a protruding manner at the central portion of the underside of the contact plate 31 of the upper electrode 11a first comes in contact with the glass substrate 4. By the contact, the upper electrode 11a creates a negative electric potential to the glass substrate 4, and the lower electrode 10 creates a positive electric potential to the electrically conductive substrate 3. Thus, bonding between the electrically conductive substrate 3 and the glass substrate 4 is started. The applied voltage is, as one example, a direct current voltage of 600 V.

The inside of the container 2 is reduced in pressure to be evacuated. This produces the effect of being capable of expelling air, which causes the occurrence of voids, to the outside of the container. With anodic bonding, in general, a little larger region than the contact region undergoes bonding. Upon completion of bonding, the applied current decreases. Therefore, by the reduction of the applied current, the bonding by contact with the small electrode 2 is judged as having been completed. Then, the contact plate 31 is brought in contact with the glass substrate 4 to perform bonding of the entire surface. This procedure prevents voids from occurring, which enables uniform bonding of the entire surface.

In order to prevent the occurrence of voids at the bonding part between the substrates, it is ideal to bond the central portions of the substrates, and to gradually proceed with the bonding toward the outer edges of the substrates. This is because the process enables the air which may cause voids to be expelled.

In this regard, the contact plate 31 is provided with the small electrode 32 protruding at the central portion. Therefore, it comes in contact therewith at the central portion. Thus, the region is subjected to bonding. Further, when the upper electrode 11a is moved downward, the whole of the contact plate 31 comes in contact therewith, so that bonding is performed on the remaining portion of the substrate surface. Therefore, it becomes possible to gradually proceed with the bonding while expelling air, which may cause voids, from the central portion toward the outer edge of each substrate. Thus, it is possible to finally complete the bonding of the entire surface.

Besides, for the upper electrode 11a, a biasing member 33 is provided between the main body part 13a and the contact plate 31. Therefore, if the contact plate 31 is not parallel with the glass substrate 4, it is possible to cancel the partial contact of the upper electrode 11a (contact plate 31) by the action of the biasing member 33. As a result, it becomes possible to resolve the problems such as breakage of the substrates and the occurrence of voids.

When anodic bonding is carried out, the electrically conductive substrate 3 and the glass substrate 4 are required to be heated. As for this, a heat source (not shown) is mounted in the main body part 13a of the upper electrode 11a. Thus, the contact plate 31 is heated via the biasing member 33 or the contact plate engagement part 34, or both the biasing member 33 and the contact plate engagement part 34. The heated contact plate 31 comes in contact with the glass substrate 4, so that the glass substrate 4 is heated. The heating method has no particular restriction. However, for example, there is a method in which the heat source to be mounted is a resistance wire heater. Incidentally, even the following method is acceptable. A lamp heater is set on the underside of the main body part 13a for heating by irradiation on the top surface of the contact plate 31. Alternatively, it may be configured such that a heat source such as a resistance wire heater is mounted in the contact plate 31

On the other hand, a heat source (not shown) is also mounted in the lower electrode 10. The heat source is, for example, a resistance wire heater. By heating the lower electrode 10, the electrically conductive substrate 3 is heated.

As a result of the foregoing, it is possible to heat the electrically conductive substrate 3 and the glass substrate 4. As one example, it is configured such that the electrically conductive substrate 3 and the glass substrate 4 are heated to 300 °C.

As described up to this point, with the anodic bonding apparatus 1a in accordance with an embodiment of the invention, it becomes possible to gradually proceed the bonding in a decompression container in which air causing the occurrence of voids has been reduced, and further while expelling air which may cause voids from the central portion toward the outer edge of each substrate.

Further, it is possible to cancel the partial contact of the upper electrode 11a (contact plate 31). As a result, it becomes possible to resolve the problems such as breakage of the substrates and the occurrence of voids.

## Claims

1. An anodic bonding apparatus (1; 1b) for bonding a laminate comprising an electrically conductive substrate (3) and a glass substrate (4), the anodic bonding apparatus comprising:
a lower electrode (10),
an upper electrode (11)
the upper electrode (11) is configured in a movable manner in the vertical direction so as to contact to and separate from the laminate, **characterized in that** the upper electrode comprises:
a main body part (13);
an electrically conductive metal thin plate (12) adapted to be contacted with the laminate; and
a space part (15) adapted for a fluid being supplied into and drained from, the space part being between the main body part and the electrically conductive metal thin plate,
wherein the electrically conductive metal thin plate has a diaphragm structure to be deformed based on a pressure difference between the space part (15) and the inside of a container (2),
the electrically conductive metal thin plate is positioned at the main body part so as to swell in a convex form in the direction to the laminate when the space part is higher in pressure than the inside of the container; and
the anodic bonding apparatus further comprises:
the container (2) of which pressure is designed to be reduced, wherein the upper electrode is disposed in the container;
a heat source for heating the electrically conductive substrate and for heating the glass substrate.

2. The anodic bonding apparatus according to claim 1,
wherein the electrically conductive metal thin plate (12) is positioned at the main body part such that, when the electrically conductive metal thin plate swells in a convex form in the direction of the laminate, the tip of the swelling matches the vicinity of the central portion of the laminate.

3. The anodic bonding apparatus according to any of claims 1 or 2,
wherein an air pressure adjuster (25) is disposed at a point in a channel through which the fluid is supplied into and drained from the space part (15).

4. The anodic bonding apparatus according to any of claims 1 to 3,
wherein the electrically conductive metal thin (12) plate comprises a stainless steel alloy thin plate.

## Patentansprüche

1. Anodische Bindungsvorrichtung (1;1b) zum Binden eines Schichtstoffs, der ein elektrisch leitendes Substrat (3) und ein Glassubstrat (4) umfasst, wobei die anodische Bindungsvorrichtung aufweist:
eine untere Elektrode (10),
eine obere Elektrode (11),
wobei die obere Elektrode (11) in der Vertikalrichtung in einer beweglichen Weise derart eingerichtet ist, dass sie den Schichtstoff berührt und sich von ihm ablöst, **dadurch gekennzeichnet, dass** die obere Elektrode umfasst:
ein Hauptkörperabschnitt (13);
eine elektrisch leitfähige dünne Metallplatte (12), die geeignet ist, mit dem Schichtstoff kontaktiert zu werden; und
ein Raumabschnitt (15), der eingerichtet ist, dass ihm ein Fluid zugeführt und aus ihm abgeführt wird, wobei der Raumabschnitt zwischen dem Hauptkörperabschnitt und der elektrisch leitenden dünnen Metallplatte angeordnet ist,
wobei die elektrisch leitende dünne Metallplatte eine Membranstruktur aufweist, die auf Basis einer Druckdifferenz zwischen dem Raumabschnitt (15) und dem Inneren eines Behälters (2) verformbar ist, wobei die elektrisch leitende dünne Metallplatte an dem Hauptkörperabschnitt so angeordnet ist, dass sie sich in der Richtung zum Schichtstoff hin in eine konvexe Form ausbeult, wenn der Druck im Raumabschnitt höher als im Inneren des Behälters ist; und
die anodische Bindungsvorrichtung ferner aufweist:
den Behälter (2), dessen Druck ausgelegt ist, reduziert zu werden, wobei die obere Elektrode im Behälter angeordnet ist;
eine Wärmequelle zum Aufheizen des elektrisch leitenden Substrats und zum Aufheizen des Glassubstrats.

2. Anodische Bindungsvorrichtung nach Anspruch 1, wobei die elektrisch leitende dünne Metallplatte (12) am Hauptkörperabschnitt derart positioniert ist, dass dann, wenn sich die elektrisch leitende dünne Metallplatte zu einer konvexen Form in die Richtung des Schichtstoffs ausbeult, die Spitze der Ausbeulung in der Nähe des Mittelteils des Schichtstoffs liegt.

3. Anodische Bindungsvorrichtung nach Anspruch 1 oder 2, wobei eine Luftdruckeinstellvorrichtung (25) an einem Punkt in einem Kanal angeordnet ist, durch welchen das Fluid dem Raumabschnitt (15) zugeführt und aus ihm abgeführt wird.

4. Anodische Bindungsvorrichtung nach einem der Ansprüche 1 bis 3, wobei die elektrisch leitende dünne Metallplatte (12) eine dünne Platte aus einer rostfreien Stahllegierung umfasst.

## Revendications

1. Appareil de liaison anodique (1 ; 1b) pour lier un stratifié comprenant un substrat électriquement conducteur (3) et un substrat de verre (4), l'appareil de liaison anodique comprenant :
une électrode inférieure (10),
une électrode supérieure (11),
l'électrode supérieure (11) est configurée d'une manière mobile dans la direction verticale de façon à entrer en contact avec le stratifié et à s'en séparer,
**caractérisé en ce que** l'électrode supérieure comprend :
une partie de corps principale (13) ;
une fine plaque de métal électriquement conductrice (12) apte à entrer en contact avec le stratifié ; et
une partie d'espace (15) apte à ce qu'un fluide soit fourni dans celle-ci et drainé de celle-ci, la partie d'espace étant entre la partie de corps principale et la fine plaque de métal électriquement conductrice,
dans lequel la fine plaque de métal électriquement conductrice a une structure de diaphragme à déformer sur la base d'une différence de pression entre la partie d'espace (15) et l'intérieur d'un conteneur (2), la fine plaque de métal électriquement conductrice est positionnée à la partie de corps principale de manière à gonfler dans une forme convexe dans la direction du stratifié lorsque la partie d'espace a une pression supérieure à celle de l'intérieur du conteneur ; et
l'appareil de liaison anodique comprend en outre :
le conteneur (2) dont la pression est conçue pour être réduite, l'électrode supérieure étant disposée dans le conteneur ;
une source de chaleur pour chauffer le substrat électriquement conducteur et pour chauffer le substrat de verre.

2. Appareil de liaison anodique selon la revendication 1,
dans lequel la fine plaque de métal électriquement conductrice (12) est positionnée à la partie de corps principale de sorte que, lorsque la fine plaque de métal électriquement conductrice gonfle dans une forme convexe dans la direction du stratifié, l'extrémité du gonflement correspond au voisinage de la partie centrale du stratifié.

3. Appareil de liaison anodique selon l'une quelconque des revendications 1 et 2,
dans lequel un ajusteur de pression d'air (25) est disposé à un point dans un canal à travers lequel le fluide est fourni dans la partie d'espace (15) et en est drainé.

4. Appareil de liaison anodique selon l'une quelconque des revendications 1 et 3,
dans lequel la fine plaque métallique électriquement conductrice (12) comprend une fine plaque d'alliage d'acier inoxydable.
